# EUROPÄISCHE PATENTSCHRIFT

(11) **EP 0 617 462 B1**
(45) Veröffentlichungstag und Bekanntmachung des Hinweises auf die Patenterteilung: **28.04.1999**
(21) Anmeldenummer: 94102740.1
(22) Anmeldetag: 23.02.1994
(51) Int. Cl.: H01L 21/324, H01L 21/28, H01L 29/43, H01L 21/3105

(54) **Amorpher wasserstoffhaltiger Kohlenstoff**
Hydrogen containing amorphous carbon
Carbone amorphe contenant de l'hydrogène

(30) Priorität: 09.03.1993 DE 4307425
(43) Veröffentlichungstag der Anmeldung: 28.09.1994
(73) Patentinhaber: SIEMENS AKTIENGESELLSCHAFT, 80333 München (DE)
(72) Erfinder: Hammerschmidt, Albert, Dr., D-91056 Erlangen (DE); Mandel, Thomas, D-90439 Nürnberg (DE)

(56) Entgegenhaltungen:
- EP-A- 0 472 055
- EXTENDED ABSTRACTS, Bd.82, Nr.1, Mai 1982, PRINCETON, NEW JERSEY US Seiten 358 - 359 N.S.SAKS 'FABRICATION OF MNOS CAPACITORS WITH ULTRA-LOW INTERFACE STATE DENSITY BY HYDROGEN IMPLANTATION'

## Beschreibung

Die Erfindung betrifft ein Verfahren zur Herstellung von amorphem wasserstoffhaltigem Kohlenstoff mit niedriger Grenzflächenzustandsdichte, nach diesem Verfahren hergestellten amorphen wasserstoffhaltigen Kohlenstoff sowie dessen Verwendung.

Schichten aus amorphem wasserstoffhaltigem Kohlenstoff, kurz a-C:H, können nach einem PECVD-Verfahren ("Plasma Enhanced CVD") aus einem beispielsweise mittels Radiofrequenz angeregten Plasma (mit kapazitiver Ankopplung des Senders) hergestellt werden. Derartige Schichten weisen im allgemeinen Bulk-Defektdichten am Fermi-Niveau von 10¹⁶ bis 10²⁰ cm⁻³ auf (siehe dazu: "Thin Solid Films", Vol. 182 (1989), Seiten 63 bis 78; "Proc. Electrochem. Soc. 91-8 - Proc. Int. Symp. Diamond Mater., 2nd", 1991, Seiten 645 bis 652; R.E. Clausing et al. "Diamond and Diamond-like Films and Coatings", Nato ASI Series B (Physics), Vol. 266, Plenum Press, New York 1991, Seiten 427 bis 437). Derartige Defekte können - wie bei amorphem Silicium (a-Si) - auf ungepaarte Elektronen, d.h. Radikale, oder auf Kohlenstoff- bzw. Graphit-Cluster zurückgeführt werden.

Bei der Anwendung von a-C:H in MISFETs, d.h. MIS-Feldeffekttransistoren (siehe beispielsweise EP-OS 0 472 055), spielen vor allem die Grenzflächenzustandsdichten, d.h. die Haftstellen für elektrische Ladungen, eine entscheidende Rolle. Hohe Zustandsdichten bewirken nämlich unterschiedliche, nicht reproduzierbare Schwellenspannungen bei den Schaltvorgängen entsprechender Transistoren. Darüber hinaus beeinflussen Grenzflächenzustände den Verstärkungsfaktor von Bauelementen, weil nicht jede Ladung am Gate durch eine zusätzliche Ladung in der Inversionsschicht kompensiert wird; vielmehr werden Grenzflächenzustände teilweise umgeladen. Weiterhin werden hohe Gate-Spannungen zur Modulation der Leitfähigkeit benötigt (siehe dazu E.H. Nicollian, J.R. Brews "MOS (Metal Oxide Semiconductor) Physics and Technology", John Wiley & Sons, New York 1982, Seiten 18 bis 22).

In herkömmlicher Weise nach unterschiedlichen Verfahren abgeschiedene a-C:H-Filme zeigen - auf verschiedenen Substraten - Grenzflächenzustandsdichten im Bereich von > 10¹¹ bis ca. 10¹⁴ cm⁻².eV⁻¹ (siehe dazu: "Solid-State Electron.", Vol. 29 (1986), Seiten 933 bis 940; "J. Vac. Sci. Technol. A", Vol. 4 (1986), Seiten 1013 bis 1017). Beispiele dafür sind:
- InP (RF-Plasmaabscheidung): 1 bis 8.10¹² bzw. 10¹² bis 10¹³ cm⁻².eV⁻¹;
- InP (Ionenstrahlabscheidung): 3 bis 5.10¹² cm⁻²,eV⁻¹;
- GaAs (Ionenstrahlabscheidung): 1 bis 20.10¹³ cm⁻².eV⁻¹;
- Si (Ionenstrahlabscheidung): 5,10¹¹ cm⁻².eV⁻¹.
Eigene Untersuchungen ergaben bei einer Abscheidung auf Silicium mittels eines hochfrequenzangeregten Plasmas einen Wert von 1 bis 3.10¹² cm⁻².eV⁻¹.

Für funktionsfähige Gate-Isolationen sind Grenzflächenzustandsdichten im angegebenen Bereich aber nicht ausreichend. Hierfür ist vielmehr eine niedrigere Zustandsdichte erforderlich, d.h. eine Zustandsdichte etwa im Bereich von 10¹⁰ bis 10¹¹ cm⁻².eV⁻¹. Mit den herkömmlichen Verfahren konnten derartige Werte bislang aber nicht erreicht werden.

Aufgabe der Erfindung ist es, eine geeignete Maßnahme anzugeben, welche die Herstellung von a-C:H-Schichten mit einer Grenzflächenzustandsdichte ≤ 5.10¹¹ cm⁻².eV⁻¹ erlaubt.

Dies wird erfindungsgemäß dadurch erreicht, daß auf einem Halbleitersubstrat durch Plasmaabscheidung erzeugte a-C:H-Schichten bei erhöhtem Druck und erhöhter Temperatur einer Behandlung mit Wasserstoff unterworfen werden.

Bei der erfindungsgemäßen Wasserstoff-Hochdruckbehandlung ergibt sich eine beträchtliche Erniedrigung der Grenzflächenzustandsdichte, und zwar etwa um den Faktor 10 bis 30. Außerdem resultiert dabei, wie entsprechende Messungen zeigen, eine Erhöhung des spezifischen elektrischen Widerstandes etwa um den Faktor 40. Dabei ist wesentlich, daß die Schichten auch nach der Wasserstoffbehandlung haftfest sind.

Beim erfindungsgemäßen Verfahren werden auf Halbleitersubstrate - insbesondere aus Silicium (Si), Siliciumcarbid (SiC), Galliumarsenid (GaAs) oder Indiumphosphid (InP) - mittels Plasmaabscheidung aufgebrachte a-C:H-Schichten beispielsweise in einem Autoklaven bei erhöhtem Druck und erhöhter Temperatur mit Wasserstoff behandelt. Der Druck beträgt dabei im allgemeinen etwa 50 bis 1500 bar (1 bar = 10⁵ Pa) vorzugsweise bis zu ca. 1000 bar. Die Temperatur liegt im allgemeinen etwa zwischen 100 und 500°C, vorzugsweise beträgt sie bis zu ca. 350°C. Die Wasserstoffbehandlung dauert mehrere Stunden, im allgemeinen etwa 1 bis 10 h.

Bei der Hochdruckbehandlung kann dem Wasserstoff vorteilhaft ein Inertgas zugesetzt werden. Vorzugsweise dient dazu ein Edelgas, insbesondere Argon oder Helium. Der Inertgasanteil beträgt im allgemeinen etwa 1 bis 50 Vol.-%.

Amorpher wasserstoffhaltiger Kohlenstoff, der nach dem erfindungsgemäßen Verfahren hergestellt ist, weist eine Grenzflächenzustandsdichte ≤ 5.10¹¹ cm⁻².eV⁻¹ auf. Derartiger Kohlenstoff eignet sich hervorragend als Gate-Isolierung in MIS-Feldeffekttransistoren, insbesondere bei GaAs-MISFETs.

Anhand eines Ausführungsbeispiels soll die Erfindung noch näher erläutert werden.

Eine Siliciumscheibe vom p-Typ (Widerstand: 60 Ω.cm) wird - nach einer Vorbehandlung (Sputtern in Argon für 2 min bei einer Selfbias-Spannung von -800 V) - in einem RF-angeregten (RF = Radiofrequenz, d.h. 0,1 bis 100 MHz), kapazitiv angekoppelten CH₄-Plasma (siehe dazu beispielsweise DE-OS 37 25 700 bzw. US-PS 5 055 421) bei einem Druck von 1 mbar und einer Selfbias-Spannung von -420 V mit a-C:H beschichtet (Schichtdicke: 0,45 µm). An dem dabei erhaltenen a-C:H (optischer Bandabstand: 1,06 eV) wird eine Grenzflächenzustandsdichte zwischen 10 und 30.10¹¹ cm⁻².eV⁻¹ ermittelt (Auswertung nach E.H. Nicollian et al., a.a.0., Seiten 325 bis 328).

Das derart mit a-C:H beschichtete Si-Substrat wird - in einem entsprechenden Quarzeinsatz - in einem Autoklaven mit Wasserstoff mit einem Druck von ca. 200 bar beaufschlagt und für die Dauer von 8 h auf einer Temperatur von ca. 275°C gehalten (Innendruck: ca. 300 bar). Nach der Behandlung mit Wasserstoff wird die Grenzflächenzustandsdichte zu 1 bis 3.10¹¹ cm⁻².eV⁻¹ ermittelt, d.h. sie hat beträchtlich abgenommen. Mittels der RBS-Methode (RBS = Rutherford Backscattering Spectrometry) wird festgestellt, daß sich gleichzeitig das Wasserstoff/Kohlenstoff-Verhältnis von 0,36 auf 0,44 erhöht hat, d.h. bei der H₂-Hochdruckbehandlung wird in den a-C:H Wasserstoff eingebaut.

## Patentansprüche

1. Verfahren zur Herstellung von amorphem wasserstoffhaltigem Kohlenstoff (a-C:H) mit niedriger Grenzflächenzustandsdichte, **dadurch gekennzeichnet,** daß auf einem Halbleitersubstrat durch Plasmaabscheidung erzeugte a-C:H-Schichten bei einem Druck von 50 bis 1500 bar (5x10⁶ - 15x10⁷ Pa) und einer Temperatur von 100 bis 500°C einer Behandlung mit Wasserstoff unterworfen werden.

2. Verfahren nach Anspruch 1, **dadurch gekennzeichnet,** daß dem Wasserstoff ein Inertgas zugesetzt wird.

3. Verfahren nach Anspruch 2, **dadurch gekennzeichnet,** daß ein Edelgas, insbesondere Argon oder Helium, zugesetzt wird.

4. Verfahren nach Anspruch 2 oder 3, **dadurch gekennzeichnet,** daß der Inertgasanteil 1 bis 50 Vol.-% beträgt.

5. Verfahren nach einem der Ansprüche 1 bis 4, **dadurch gekennzeichnet,** daß die Behandlung mit Wasserstoff bei einem Druck bis zu ca. 1000 bar erfolgt.

6. Verfahren nach einem oder mehreren der Ansprüche 1 bis 5, **dadurch gekennzeichnet,** daß die Behandlung mit Wasserstoff bei einer Temperatur bis zu ca. 350°C erfolgt.

7. Verfahren nach einem oder mehreren der Ansprüche 1 bis 6, **dadurch gekennzeichnet,** daß die Behandlung mit Wasserstoff in einem Zeitraum von mehreren Stunden erfolgt.

8. Verfahren nach einem oder mehreren der Ansprüche 1 bis 7, **dadurch gekennzeichnet,** daß das Halbleitersubstrat Silicium, Siliciumcarbid, Galliumarsenid oder Indiumphosphid ist.

9. Amorpher wasserstoffhaltiger Kohlenstoff in Form einer plasmaabgeschiedenen Schicht auf einem Halbleitersubstrat, **gekennzeichnet** durch eine Grenzflächenzustandsdichte ≤ 5.10¹¹ cm⁻².eV⁻¹.

10. Verwendung von amorphem wasserstoffhaltigem Kohlenstoff nach Anspruch 9 als Gate-Isolierung in MIS-Feldeffekttransistoren.

## Claims

1. Method for preparing amorphous, hydrogenated carbon (a-C:H) having a low interfacial state density, characterized in that a-C:H layers generated on a semiconductor substrate by means of plasma deposition are subjected to a treatment with hydrogen at a pressure of 50 to 1500 bar (5x10⁶-15x10⁷ Pa) and a temperature of 100 to 500°C.

2. Method according to claim 1, characterized in that an inert gas is added to the hydrogen.

3. Method according to claim 2, characterized in that a noble gas, in particular argon or helium, is added.

4. Method according to claim 2 or 3, characterized in that the portion of inert gas amounts to 1 to 50 % by volume.

5. Method according to one of claims 1 to 4, characterized in that the treatment with hydrogen takes place at a pressure of up to about 1000 bar.

6. Method according to one or more of claims 1 to 5, characterized in that the treatment with hydrogen takes place at a temperature of up to about 350°C.

7. Method according to one or more of claims 1 to 6, characterized in that the treatment with hydrogen takes place within a period of several hours.

8. Method according to one or more of claims 1 to 7, characterized in that the semiconductor substrate is silicon, silicon carbide, gallium arsenide or indium phosphide.

9. Amorphous, hydrogenated carbon in the form of a plasma-deposited layer on a semiconductor substrate, characterized by an interfacial state density ≤ 5.10¹¹ cm⁻².eV⁻¹.

10. Use of amorphous, hydrogenated carbon according to claim 9 as gate-insulation in MIS field-effect transistors.

## Revendications

1. Procédé pour la fabrication de carbone amorphe contenant de l'hydrogène (a-C : H) avec une faible densité d'état d'interface, caractérisé en ce que des couches a-C : H produites sur un substrat semi-conducteur par épitaxie par plasma sont soumises à un traitement avec de l'hydrogène sous une pression allant de 50 à 1500 bars (5. 10⁶ à 15. 10⁷ Pa) et une température allant de 100 à 500 °C.

2. Procédé selon la revendication 1, caractérisé en ce qu'un gaz inerte est ajouté à l'hydrogène.

3. Procédé selon la revendication 2, caractérisé en ce qu'un gaz rare, en particulier de l'argon ou de l'hélium, est ajouté à l'hydrogène.

4. Procédé selon la revendication 2 ou 3, caractérisé en ce que la proportion de gaz inerte vaut de 1 à 50 % en volume.

5. Procédé selon l'une des revendications 1 à 4, caractérisé en ce que le traitement avec l'hydrogène s'effectue sous une pression allant jusqu'à environ 1000 bars.

6. Procédé selon l'une ou plusieurs des revendications 1 à 5, caractérisé en ce que le traitement avec l'hydrogène s'effectue à une température allant jusqu'à environ 350 °C.

7. Procédé selon l'une ou plusieurs des revendications 1 à 6, caractérisé en ce que le traitement avec l'hydrogène s'effectue durant une période de plusieurs heures.

8. Procédé selon l'une ou plusieurs des revendications 1 à 7, caractérisé en ce que le substrat semi-conducteur est du silicium, du carbure de silicium, de l'arséniure de gallium ou du phosphure d'indium.

9. Carbone amorphe contenant de l'hydrogène sous la forme d'une couche épitaxiée par plasma sur un substrat semi-conducteur, caractérisé par une densité d'état d'interface ≤ 5. 10¹¹ cm⁻².eV⁻¹_{.}

10. Utilisation d'un carbone amorphe contenant de l'hydrogène selon la revendication 9 comme isolation de grille dans des transistors à effet de champ MIS.
